Europäisches Patentamt

European Patent Office

Office européen des brevets

(19)

(11) Veröffentlichungsnummer: **0 039 875**
**B1**

(12) **EUROPÄISCHE PATENTSCHRIFT**

(45) Veröffentlichungstag der Patentschrift:
19.03.86

(21) Anmeldenummer: 81103365.3

(22) Anmeldetag: 05.05.81

(51) Int. Cl.⁴: **H 01 L 29/743,** H 01 L 29/52,
H 01 L 29/08

(54) Thyristor.

(30) Priorität: 08.05.80 DE 3017584

(43) Veröffentlichungstag der Anmeldung:
18.11.81 Patentblatt 81/46

(45) Bekanntmachung des Hinweises auf die Patenterteilung:
19.03.86 Patentblatt 86/12

(84) Benannte Vertragsstaaten:
**CH FR GB IT LI**

(56) Entgegenhaltungen:
**EP - A - 0 002 840**
**DE - A - 2 339 440**
**DE - A - 2 542 901**
**DE - A - 2 830 625**
**US - A - 3 599 061**
**US - A - 4 060 825**

(73) Patentinhaber: **SEMIKRON, GESELLSCHAFT FÜR
GLEICHRICHTERBAU UND ELEKTRONIK M.B.H.,
Sigmundstrasse 200, D-8500 Nürnberg 82 (DE)**

(72) Erfinder: **Tursky, Werner, Dipl.-Ing. Dr.,
Aldringerstrasse 15, D-8500 Nürnberg (DE)**

LIBER, STOCKHOLM 1986

## Beschreibung

Die Erfindung betrifft einen Thyristor, dessen Halbleiterkörper eine Folge von wenigstens vier schichtförmigen Zonen abwechselnd entgegengesetzten Leitungstyps mit eine die Steuerelektrode wenigstens teilweise umschließenden Emitterzone mit Durchbrüchen zum Durchgriff der angrenzenden Basiszone bis zur Emitterelektrode aufweist, gemäß dem Oberbegriff des Anspruchs 1.

Bei Thyristoren mit sogenannten Emitterkurzschlüssen tritt die mit der Steuerelektrode versehene Basiszone in Durchbrüchen der angrenzenden Emitterzone durch die Letztere hindurch an die gemeinsame Oberfläche, und diese durchtretenden Teile der Basiszone sind über die Emjtterelektrode gemeinsam elektrisch kontaktiert und schließen die Emitterzone kurz. Tritt am Thyristor eine Blockierspannung hoher Steilheit auf, so fließt wegen der kapazitiven Wirkung des sperrenden pn-Übergangs ein Teil des Verschiebungsstromes über die Durchbrüche direkt in die Emitterelektrode. Dadurch wird die Injektionswirkung der Emitterzone in die angrenzende Basiszone reduziert, so daß bei entsprechender Dichte der Durchbrüche eine Zündung des Thyristors verhindert wird.

Bei bekannten Ausführungsformen von Thyristoren sind die Durchbrüche in quadratischem, hexagonalem, strahlenförmigem oder evolventenförmigem Muster angeordnet. So ist es aus der deutschen patentschrift 21 23 322 bekannt, Durchbrüche auf strahlenförmig von der Steuerelektrode ausgehenden Linien anzubringen. Um eine gewisse Mindestdichte der Durchbrüche über die Emitterfläche zu erreichen, sind bei zunehmendem Abstand benachbarter Strahlen auf der Winkelhalbierenden zwischen denselben zusätzliche Durchbrüche vorgesehen. Eine solche Anordnung zeigt jedoch nicht die für eine Optimierung des du/dt-Verhaltens geforderte, gleichmäßige Dichte der Durchbrüche.

Insbesondere bei der für die Funktion des Thyristors vorteilhaften Lage einer kreisförmigen Steuerelektrode im Zentrum der einen Hauptfläche zeigen die Muster der Durchbrüche bei bekannten Anordnungen teilweise die Nachteile ungleicher Abstände, unterschiedlicher Dichte sowie ungenügender Zündausbreitung.

Weiter ist aus der deutschen patentschrift 24 38 894 ein Thyristor mit Emitterkurzschlüssen bekannt, die einen Durchmesser gleich oder kleiner 2O/um haben, und bei welchen das Verhältnis des Abstandes zweier benachbartei Kurzschlüsse zu ihrem Durchmesser größer oder gleich 3 ist. Da beide Verhältnisgrößen und damit auch das Verhältnis selbst wählbar sjnd, ist aus der angegebenen Bemessungsvorschrift kein Hinweis zu erkennen, wie mit einem Muster zur Anordnung der Durchbrüche, insbesondere im Bereich nahe der Steuerelektrode, eine Optimierung sowohl des du/dt-Verhaltens als auch der Zündausbreitung erzielbar ist.

Der Erfindung lag die Aufgabe zugrunde, für den Halbleiterkörper eines Thyristors ein Muster zur Anordnung von Emitterkurzschlüssen anzugeben, mit welchem zumindest im Bereich nahe der Steuerelektrode eine örtlich gleichmässige Zündemfindlichkeit und im gesamten Bereich der Emitterzone eine gleichmäßige Dichte der Durchbrüche gegeben ist.

Zur Lösung der Aufgabe wird davon ausgegangen, daß die einer kreisförmigen Steuerelektrode nächstliegenden Durchbrüche auf einer konzentrischen Linie um die Steuerelektrode angebracht sind, und daß Anzahl und Lage der Durchbrüche in an sich bekannter Weise durch die gewünschte, von den Dotierungsverhältnissen vorgegebene Stabilität des du/dt-Verhaltens sowie die Geometrie der dotierten Zonen und der Emitterelektrode bestimmt sind. Hierzu wird auf K. Hartmann "improvement of thyristor-turn-on by cancellation of the gate-cathode characteristic before injection" IEEE Transactions Electron Devices Vol. ED - 23 No. 8, pp. 912 - 917, sowie auf A. Munoz-Yague and Leturcq: "Optimum design of thyristor gate emitter geometry" IEEE Transaction Electron Devices, Vol. ED - 23, 1976, No. 8, pp. 917 - 924 verwiesen.

Die Lösung der Aufgabe besteht bei einem Thyristor der eingangs erwähnten Art in den Merkmalen des kennzeichnenden Teils des Anspruchs 1.

Die Steuerelektrode kann kreisförmig oder kreishförmig ausgebildet sein, und die Durchbrüche sind dann vorteilhaft in dem der Steuerelektrode benachbarten Bereich in einem konzentrisch zur Steuerelektrode Kreisförmigen oder kreisbogenförmigen Muster angeordnet.

Vorteilhaft ist aufgrund der Vorgabe der Anzahl der Durchbrüche auf der innersten Linie der Abstand der innersten Linie zur nächsten Linie so gewählt, daß benachbarte Durchbrüche auf beiden Linien jeweils die Ecken eines annähernd gleichseitigen Dreiecks bilden, und daß benachbarte Durchbrüche auf benachbarten Linien nicht auf einer von der Steuerelektrode ausgehenden Geraden liegen. Das Muster gemäß der Erfindung ist weiter so ausgebildet, daß jede der zur Steuerelektrode konzentrischen Linien die gleiche Anzahl von Durchbrüüchen und annähernd gleichen Abstand zu den benachbarten Linien aufweist, und daß das Verhältnis der Fläche der Durchbrüche jeder Linie zur Fläche des zugeordneten Emitterzonenabschnittes im wesentlichen konstant ist.

Bei konzentrisch zur Steuerelektrode kreisförmigem Muster soll das verhältnis der Radien von äußerstem Kreis und innerstem Kreis maximal 4 sein.

Vorzugsweise sind die Durchbrüche kreischförmig ausgebildet und in einem konzentrisch zur steuerelektrod, kreisförmigen Muster angeordnet.

Stellung der gewünschten Dichte der Durchbrüche im Bereich des Übergangs vom Muster mit Linien gleichbleibenden Abstandes zur Steuerelektrode in das zweite vieleckförmige Muster weisen diejenigen Vielecke des Letzteren, die an eine Linie stoßen oder von einer Linie zerteilt werden, ohne daß ein Durchbruch der Linie in ihre Fläche fällt im Zentrum ihrer Fläche jeweils einen zusätzlichen Durchbruch auf.

Die Durchbrüche im übrigen Bereich der Emitterzone sind vorzugsweise in rechteckförmigem oder dreieckförmigem Muster angeordnet.

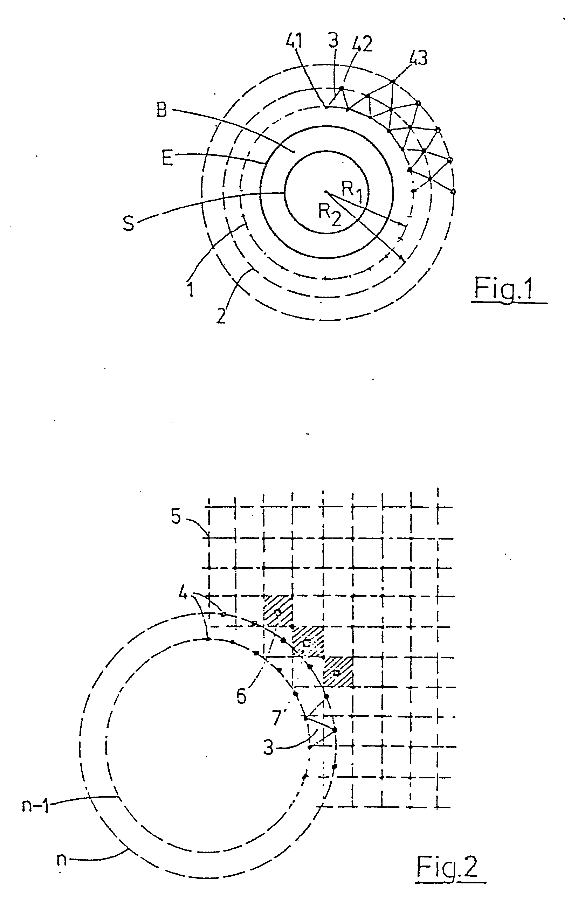

Anhand der zur Veranschaulichung stark vergrößerten, beispielhaften Darstellung eine Anordnung von Durchbrüchen in den Figuren 1 und 2 wir der Gegenstand der Erfindung aufgezeigt und erläutert. Figur 1 zeigt einen Teil eines kreisförmigen konzentrich zur Steuerelektrode Musters mit kreisförmigen Durchbrüchen in dem der Steuerelektrode benachbarten Bereich der Emitterzone, und in Figur 2 ist jeweils ein Teil beider Muster mit gegenseitiger Überlagerung dargestellt.

Für gleiche Teile sind in beiden Figuren gleiche Bezeichnungen gewählt.

Bei dem Ausführungsbeispiel eines Halbleiterkörpers gemäß Figur 1 ist die kreisförmige Steuerelektrode S im Zentrum einer Halbleiterscheibe vom Innenrand E der Emitterzone konzentrisch umschlossen. Die Lage des erten Kreises 1 mit dem Radius $R_1$ und der Durchbrüche 41 ist durch funktionsbedingte und technologische Gesichtspunkte in bekannter Weise bestimmt. Weiterhin ist der Kreis 1 konzentrisch von einem Kreis 2 mit Durchbrüchen 42 umschlossen. Der gegenseitige Abstand der beiden Kreise ist dadurch bestimmt, daß benachbarte Durchbrüche 41 und 42 der beiden Kreise jeweils die Ecken annähernd gleichseitiger Dreiecke bilden. Diese Vorschrift ergjbt eine regelmäßige Anordnung einer gleichen Anzahl von Durchbrüchen auf allen Kreisen. Mit diesem regelmäßigen Muster der Dürchbrüche ist aber auch eine regelmäßige Anordnung von Zündausbreitungskanälen in der Nähe der Steuerelektrode gegeben.

Die gleichmäßige Dichte der Durchbrüche zwecks Optimierung des du/dt-Verhaltens ist dadurch gewährleistet, daß die Gesamtfläche aller Durchbrüche jedes an den Kreis 1 anschließenden weiteren Kreises entsprechend der Zunahme der Kreisflächen und dadurch auch der Flächen der zugeordneten Emitterzonenabschnitte angepaßt vergrößert wird. Die Vergrößerung soll angepaßt sein, indem das Verhältnis der Fläche der Durchbrüche zweier Kreise gleich dem Verhältnis der durch den jeweiligen Radius der beiden Kreise bestimmten Fläche der zugeordneten Ermitter zouenabschnitte ist.

Demzufolge ist beispielsweise die Gesamtfläche aller Durchbrüche eines Kreises mit gegenüber dem ersten Kreis vierfachem Radius gleich dem vierfachen der Gesamtfläche aller Durchbrüche des ersten Kreises. Sie ist dadurch beschränkt, daß das wegen der Optimierung der Zündausbreitung vorteilhafte kreisförmige Muster der Durchbrüche bei einer beträchtlichen Ausdehnung desselben in die Emitterzone eine zu geringe Anzahl von Durchbrüchen liefert, wodurch das du/dt-Verhalten in der Nähe der Steuerelektrode beeinträchtigt wird. Mit kreisförmigem Muster in einem Bereich mit maximal vierfachem Radius des äußersten Kreises n gegenüber dem Kreis 1 wurden günstige Ergebnisse erzielt. Beispielsweise kann bei einem Halbleiterkörper mit einem Durchmesser der Emitterfläche von 23mm der Bereich mit konzentrischer Anordnung der Durchbrüche eine Fläche von 14% der Emitterfläche einnehmen.

Tritt an den nicht dargestellten Laststromelektroden eine Blockierspannung hoher Steilheit auf, so fließt aufgrund der Sperrschichtkapazität des Thyristors ein Verschiebungsstrom zu der auf der Emitterzone aufgebrachten Emitterelektrode. Dieser Strom fließt jedoch nur zum Teil in die Emitterzone (E). Der andere Teil fließt durch die Durchbrüche 41, 42, 43 usw. der Basiszone B in die Emitterelektrode und den darauf befestigten, ebenfalls nicht dergestellten Stromleiter. Dadurch wird die Injektionswirkung der Emitterzone entsprechend reduziert, so daß der Thyristor nicht zündet. Eine Zündung kann nur aufgrund einer Spannung höherer Steilheit erfolgen.

Bei dem in Figur 2 dargestellten Ausführungsbeispiel schließt an das konsentrisch zur Steuerelektroden kreisförmige Muster in dem der Steuerelektrode benachbarten Bereich ein quadratisches Muster im übrigen Bereich an. Zur Sicherstellung der geforderten Dichte der Durchbrüche S sind die beiden Muster im Grenzgebiet in der Weise überlegert, daß das quadratische Muster vom Emitteraußenrand nach innen bis über den äußeren Kreis n ausgedehnt ist, und daß die den Kreis n berührenden -oder überlappenden, quadratischen Flächenabschnitte 7, soweit in sie kein Durchbruch des konzentrisch zur Steuerelektroden kreisförmigen Musters fällt, jeweils nicht an ihren Ecken auf dem oder innerhalb des Kreises n, sondern in ihrem Zentrum mit einem zusätzlichen Durchbruch 6 versehen sind. Dessen Flächenausdehnung kann derjenigen der re-gelmäßigen Durchbrüche entsprechen.

In gleicher Weise ist ein Übergang von dem konzentrisch zur Steuerelektrode kreisförmigem Muster zu rautenförmigem oder hexagonalem Muster erzielbar.

Die Vorteile des Gegenstandes der Erfindung bestehen darin, daß sowohl in der Nähe der Steuerelektrode als auch im übrigen Bereich durch einfache Bemessungsvorschriften Durchbrüche in regelmäßiger Anordnung und gleichmäßiger Dichte angebracht sind, und daß durch die unterteilte Anordnung Zündausbreitung und du/dt-Verhalten im ganzen Emitterzonenbereich optimiert sind.

## Patentansprüche

1. Thyristor, dessen Halbleiterkörper eine Folge von wenigstens vier schichtförmigen Zonen abwechselnd entgegengesetzten Leitungstyps aufweist mit einer die Steuerelektrode (S) wenigstens teilweise umschließen-den Emitterzone (E), welche mit, insbesondere kreisförmigen, Durchbrüchen (4) zum Durchgriff der angrenzenden Basiszone (B) bis zur Emitterelektrode versehen ist, und bei dem der der Steuerelektrode benachbarte, kleinere Bereich der Emitterzone Durchbrüche (4) gleichen Abstandes zur Steuerelektrode und der übrige, größere Bereich der Ermitterzone Durchbrüche einem andereln Muster aufweist, dadurch gekennzeichnet, daß das von den Durchbrüchen gebildete Muster vieeckförmig ist, daß der der Steuerelektrode (S) benachbarte Bereich der Ermitterzone Durchbrüche aufweist, die ein Muster auf Linien. jeweils gleichbleibenden Abstandes (1, 2) zur Steuerelektrode erzeugen wobei aufjeder linie eine gleiche Anzahl von Durchbrüchen (41, 42, 43) vorhanden ist, und daß im Übergangsgebiet zwischen die Durchbrüche enthaltenden Mustern diejenigen Vielecke (7), die an die äußerste der Linien gleichbleibenden Abstandes (1, 2) zur Steuerelektrode (S) stoßen oder von dieser äußersten Linie zerteilt werden, ohne daß Durchbrüche auf dieser Linie in die jeweilige Vieleckfläche fallen, im Zentrum ihrer Fläche jeweils einen zusätzlichen Durchbruch (6) aufweisen.

2. Thyristor nach Anspruch 1, bei dem die Steuerelektrode kreisförmig oder kreisbogenförmig ausgebildet ist und die Durchbrüche in dem der Steuerelektrode benachbarten Bereich in einem kreisförmigen oder kreisbogenförmigen Muster konzentrisch zur Steuerelektrode angeordnet sind, dadurch gekennzeichnet, daß jede der zur Steuerelektrode (S) konzentrischen Linien (1, 2) annähernd den gleichen Abstand zu den benachbarten Linien aufweist.

3. Thyristor nach Anspruch 1, bei dem die Steuerelektrode kreisförmig oder kreisbogenförmig ausgebildet ist und die Durchbrüche in dem der Steuerelektrode benachbarten Bereich in einem kreisförmigen oder kreisbogenförmigen Muster konzentrisch zur Steuerelektrode angeordnet sind, dadurch gekennzeichnet, daß der gegenseitige Abstand der Linien (1, 2) so gewählt ist, daß benachbarte Durchbrüche (41, 42) auf benachbarten Linien (1, 2) jeweils die Ecken eines annähernd gleichseitigen Dreiecks bilden.

4. Thyristor nach Anspruch 2 oder 3, dadurch gekennzeichnet, daß das Verhältnis der Fläche eines Durchbruchs zur Fläche des zugeordneten Emitterzonenabschnittes für die Durchbrüche in dem der Steuerelektrode (S) benachbarten Gebiet im wesentlichen gleichbleibend ist.

5. Thyristor nach einem der Ansprüche 2 bis 4, dadurch gekennzeichnet, daß bei kreisförmigem Muster der Radius des äußersten Kreises maximal das Vierfache gegenüber dem Radius des innersten Kreises beträgt.

6. Thyristor nach einem der Ansprüche 1 bis 5, dadurch gekennzeichnet, daß die Durchbrüche (S)! im übrigen Bereich der Emitterione in rechteckförmigem oder dreieckförmigem Muster angeordnet sind.

## Claims

1. Thyristor, with a semiconductor body which comprises a sequence of four or more lamellar zones, the conductiontypes of these zones being in opposition, in an alternating arrangement, the said semiconductor body possessing an emitter zone (E) which at least partially surrounds the control electrode (S) and which is provided with perforations (4) so that the adjoining base zone (B) can extend through to the emitter electrode, these perforations (4) exhibiting, in particular, a circular shape, and in which thyristor the smaller region of the emitter zone, which region is adjacent to the control electrode, possesses perforations (4) which are located at the same distance from the control electrode, while the remaining, larger region of the emitter zone possesses perforations in another pattern, characterized in that the perforations form a polygonal pattern, in that that region of the emitter zone which is adjacent to the control electrode (S) possesses perforations which generate a pattern on lines which, in each case, are located at a constant distance (1, 2) from the control electrode, the number of perforations (41, 42, 43) present on each line being constant, and in that, in the transition field between the patterns containing the perforations, an additional perforation (6) is possessed by each of those polygons (7) which either abut against the outermost of the lines located at a constant distance (1, 2) from the control electrode (S), or are divided by this outermost line without perforations thereon falling into the polygonal area in question, each of the said additional perforations (6) being positioned at the centroid of the polygon (7) in question.

2. Thyristor according to Claim 1, in which the control electrode is designed in the shape of a circle, or in the shape of an arc of a circle, while the perforations in the region adjacent to the control electrode are arranged in a circular or arcuate pattern, concentric with the control electrode, characterized in that each of the lines (1, 2) which are concentric with the control electrode (S) is located approximately equidistant from the adjacent lines.

3. Thyristor according to Claim 1, in which the control electrode is designed in the shape of a circle, or in the shape of an arc of a circle, while the perforations in the region adjacent to the control electrode are arranged in a circular or arcuate pattern, concentric with the control electrode, characterized in that the spacing of the lines (1, 2) is chosen to be such that adjacent perforations (41, 42) on adjacent lines (1, 2) in each case form the corners of an approximately equilateral triangle.

4. Thyristor according to Claim 2 or 3, characterized in that the ratio of the area of a perforation, to the area of that portion of the emitter zone which is allocated to the said perforation, is substantially constant for the perforations in the field adjacent to the control electrode (S).

5. Thyristor according to one of Claims 2 to 4, characterized in that, if a circular pattern is adopted, the radius of the outermost circle does not exceed that of the innermost circle by more than a factor of four.

6. Thyristor according to one of Claims 1 to 5, characterized in that the perforations (5) in the remaining region of the emitter zone are arranged in a rectangular or triangular pattern.


**Revendications**

1. Thyristor dont le corps semi-conducteur comporte une suite d'au moins quatre zones sous forme de couches, alternativement de type conducteur opposé, avec une zone émettrice (E) entourant au moins partiellement l'électrode de commande ou gâchette (S) et comportant des zones de claquage (4), plus particulièrement de forme circulaire, en vue de la pénétration électronique de la zone de base (B) adjacente jusqu'à l'électrode émettrice, où la plus petite partie de la zone émettrice, adjacente à l'électrode de commande, présente des zones de claquage situées à égale distance de l'électrode de commande, et où la partie plus grande de ladite zone émettrice présente des zones de claquage disposées selon une géométrie différente, caractérisé en ce que:
- les géométries des zones de claquage sont à base de polygones,
- la partie de la zone émettrice adjacente à l'électrode de commande (S) comporte des zones de claquage disposées sur des lignes (1), (2) dont chacune est à une distance constante de l'électrode de commande, sur chaque ligne se trouvant un nombre identique de zones de claquage (41), (42), (43),
- dans la zone de transition entre les zones à géométrie différente des zones de claquage, les polygones (7) qui touchent à la ligne située le plus à l'extérieur des lignes de zones de claquage à distances constantes (1), (2) de l'électrodede commande (S) ou qui sont diviséespar ladite ligne extérieur sans que des zones de claquage de cette ligne soient comprises dans la surface des polygones, comportent au centre de leur surface une zone de claquage supplémentaire (6).

2. Thyristor selon la revendication 1 avec une électrode de commande en forme de cercle ou d'arc de cercle,oùles zones de claquage situées dans le voisinage de l'électrode de commande sont disposées sur des cercles ou des arcs de cercles concentriques à l'électrode de commande (S), caractérisé en ce que chaque ligne (1), (2) concentrique à l'électrode de commande (S) est située à une distance sensiblement identique des lignes voisines.

3. Thyristor selon la revendication 1 avec une électrode de commande en forme de cercle ou d'arc de cercle, où les zones de claquage situées dans le voisinage de l'électrode de commande sont disposées sur des cercles ou des arcs de cercles concentriques à l'électrode de commande (S) caractérisé en ce que la distance entre les lignes (1), (2) est déterminée de sorte que des zones de claquage voisines (41), (42) disposées sur des lignes voisines, constituent les sommets d'un triangle approximativement équilatéral.

4. Thyristor selon l'une des revendications 2 et 3 caractérisé en ce que le rapport entre la surface d'une zone de claquage et la surface du segment correspondant de la zone émettrice demeure pour l'essentiel constant pour les zones de claquage situées dans le voisinage de l'électrode de commande.

5. Thyristor selon l'une des revendications 2 à 4 caractérisé en ce que dans l'hypothèse d'une géométrie à base de cercles, le rayon du cercle situé le plus à l'extérieur est au maximum quatre fois plus grand que le rayon du cercle situé le plus à l'intérieur.

6. Thyristor selon l'une des revendications 1 à 5 caractérisé en ce que les zones de claquage (5) sont disposées dans la partie restante de la zone émettrice en formant des rectangles ou des triangles.

1/1

Fig.1

Fig.2